Europäisches Patentamt

(19) European Patent Office

Office européen des brevets

(11) Publication number: 0 132 122
B1

(12) EUROPEAN PATENT SPECIFICATION

(45) Date of publication of patent specification: 09.11.88

(51) Int. Cl.⁴: G 01 N 21/88

(21) Application number: 84304754.9

(22) Date of filing: 11.07.84

(54) Apparatus for inspecting mask for use in manufacturing large scale integrated circuits.

(30) Priority: 15.07.83 JP 128913/83

(43) Date of publication of application:
23.01.85 Bulletin 85/04

(45) Publication of the grant of the patent:
09.11.88 Bulletin 88/45

(84) Designated Contracting States:
DE FR GB

(56) References cited:
EP-A-0 054 596
EP-A-0 066 466
EP-A-0 105 661
EP-A-0 114 517
GB-A-2 076 533

IBM JOURNAL OF RESEARCH AND
DEVELOPMENT, vol. 27, no. 1, January 1983,
pages 50-58, New York, US; M.A. WEST et al.:
"Computer-controlled optical testing of high-
density printed-circuit boards"

(73) Proprietor: KABUSHIKI KAISHA TOSHIBA
72, Horikawa-cho Saiwai-ku
Kawasaki-shi Kanagawa-ken 210 (JP)

(72) Inventor: Ikenaga, Osamu c/o Patent Division
Kabushiki Kaisha Toshiba 1-1 Shibaura 1-chome
Minato-ku Tokyo 105 (JP)
Inventor: Yoshikawa, Ryoichi c/o Patent
Division
Kabushiki Kaisha Toshiba 1-1 Shibaura 1-chome
Minato-ku Tokyo 105 (JP)

(74) Representative: Freed, Arthur Woolf et al
MARKS & CLERK 57-60 Lincoln's Inn Fields
London WC2A 3LS (GB)

REVIEW OF THE ELECTRICAL
COMMUNICATION LABORATORIES, vol. 30,
no. 6, 1982, pages 1076-1085, Tokyo, JP; B.
TSUJIYAMA et al.: "An automated mask defect
inspection system"

EP 0 132 122 B1

Courier Press, Leamington Spa, England.

## Description

The present invention relates to a method and apparatus for inspecting defects of an integrated-circuit-pattern transferring mask used in manufacturing large scale integrated circuits.

In manufacturing semiconductor integrated circuits, various defects of a photomask, electron-beam mask or X-ray mask adapted for transferring a circuit pattern drawn thereon onto a semiconductor wafer or an insulating wafer are possibly encountered, such as contamination, disconnection of the circuit pattern, and deformation of the pattern. The presence of such defects reduces the production yield in manufacturing semiconductor products. In a conventional defect inspection apparatus during inspection, light is projected onto a photomask; the light transmitted through the photomask is sensed by an image sensor; and the sensed signal is compared, picture element by picture element, or dot by dot, with a binary signal representing design pattern data. In the inspection, judgment that a defect is present in the pattern is made only when the difference between the measured data and the design data continues over two or three dots, allowing for the inevitable errors in measurement. This fact implies that the conventional inspection device cannot inspect defects whose size is smaller than the picture element.

An improved photomask inspection apparatus is disclosed in European Patent Application No. 83305534.6 filed September 20, 1983, priority date: 5.10.82 published under EP—A1—105661 and entitled "APPARATUS FOR INSPECTING A CIRCUIT PATTERN DRAWN ON A PHOTOMASK USED IN MANUFACTURING LARGE SCALE INTEGRATED CIRCUITS."

In this improved inspection apparatus, an analog measured signal at each measured point (light projecting point) on the photomask is converted into a multi-level digital signal, and the position of the measured point is measured more finely than the size of the picture element. From the design pattern, data not involving defects at the measuring points, multi-level reference data are calculated, allowing for the sensitivity of the image sensor used. The reference data is compared with the measured data. Therefore, a defect inspection having high accuracy can be successfully attained.

In inspecting defects of the photomask, the temperature variation observed from the manufacturing stage of the mask to the inspection stage, and the often insufficient accuracy of the manufacturing process may cause the photomask to expand or contract in the X- and Y directions, and cause a variation in the orthogonal degree of the circuit pattern. The expansion and contraction of the photomask and the deformation of the circuit pattern naturally will cause errors during the inspection of the photomask. In this respect, there is a strong demand for an inspection apparatus capable of compensating the expansion and contraction of the mask and the pattern deformation.

To effect this compensation, it is necessary to accurately align the photomask with the optical sensing system. To align the photomask with the optical sensing system, the position of a positioning mark formed on the photomask is detected and is then put at a predetermined position. As improved method for detecting the position of the positioning mark on the photomask, which is used to accurately position the photomask in an optical system, is disclosed in EP—A1—0 114 517, priority date: 27.12.82, filing date: 22.12.83, published: 1.8.84.

An object of the present invention is to provide a mask inspection method apparatus which can detect any defects of an integrated-circuit-pattern transferring mask and are not affected by deformation of the mask.

According to one aspect of the present invention, there is provided a method of inspecting a mask for use in manufacturing integrated circuit, said mask having at least three position detecting marks and a circuit pattern drawn thereon to be transferred onto a wafer, comprising the steps of: storing reference integrated circuit pattern data signals for respective pixels of a designed integrated circuit pattern drawn on said mask; placing said mask on a X—Y table for inspection; driving said X—Y table in X and Y directions of said mask; measuring a position of said X—Y table to provide a position signal used for addressing said storage means to read out a reference integrated circuit pattern data signal for each pixel of said mask; optically sensing said circuit pattern of said mask placed on said X—Y table to provide measured integrated circuit pattern signals for the respective pixels of said mask; comparing the measured integrated circuit pattern signals with the reference integrated circuit pattern data signals, read out of said storage means, for the respective pixels of said mask to detect a defect of said mask; optically detecting said position detecting marks of said mask; calculating a distortion of said mask on the basis of the detected positions of said position detecting marks of said mask; and correcting the position signal obtained for each position of said X—Y table according to an amount of the distortion of said mask so that the comparison between the reference integrated circuit pattern data signal and the measured integrated circuit pattern signal is made for each of corresponding pixels of the designed integrated circuit pattern and the drawn integrated circuit pattern on said mask.

The characteristic feature of the invention enables exact defect detection of the integrated circuit pattern to be performed without being influenced by the distortion of the mask.

According to another aspect of the present invention, there is provided an apparatus for inspecting a mask for use in manufacturing integrated circuits which has at least three position detecting marks and an integrated circuit pattern drawn thereon to be transferred onto a water, comprising: storage means for storing reference integrated circuit pattern data signals for respective pixels of a designed integrated circuit pattern drawn on said mask; an X—Y table on which said mask can be placed for inspection; table driving means for driving said X—Y table in X and Y directions of said mask; means for measuring the position of said X—Y table to provide a position signal used for adressing said storage means to read out a reference integrated circuit pattern data signal for each pixel of said mask; a source of light for illuminating said mask placed on said X—Y table; sensing means responsive to the illumination of said mask placed on said table for providing measured integrated circuit pattern signals for the respective pixels of said mask; comparing means for comparing the measured integrated circuit pattern signals with the reference integrated circuit pattern data signals, read out of said storage means, for the respective pixels of said mask to detect a defect of said mask; means for detecting said position detecting marks of said mask placed on said table and calculating a geometrical distortion of said mask according to be detected positions of said position detecting marks; and means for correcting the position signal addressing said storage means and obtained for each position of said table according to an amount of the distortion of said mask so that the comparison between the reference integrated circuit pattern data signal and the measured integrated circuit pattern signal is made for each of corresponding pixels of the designed integrated circuit pattern and the drawn integrated circuit pattern on said mask.

The measured position data of the mask, which is used for generating the reference data, is corrected to correspond to data representing the position of the design pattern on the mask, according to the geometrical distortion of the mask. In this way, the reference data may be equivalently corrected.

According to the present invention, the geometrical distortion inspection of the mask may be performed by the same inspection apparatus prior to the circuit pattern inspection. Therefore, it is possible to exclude a mask from the circuit pattern inspection, which was found, in the distortion inspection prior to the circuit pattern inspection, to have distorted over a tolerance. The result is an improvement in the throughput of the overall inspection processes.

This invention can be more fully understood from the following detailed description when taken in conjunction with the accompanying drawings, in which:

Fig. 1 is a block diagram of a photomask inspection apparatus embodying the present invention;

Fig. 2 schematically illustrates a structure of an image sensor in a signal detector in the circuit of Fig. 1;

Fig. 3 illustrates in block form a position data correction circuit;

Fig. 4 shows the arrangement of position detecting marks on a photomask;

Fig. 5 is a diagram useful in explaining how to detect the center position of each position detecting mark on the photomask; and

Fig. 6 comparatively illustrates a design pattern and a distorted pattern of a photomask.

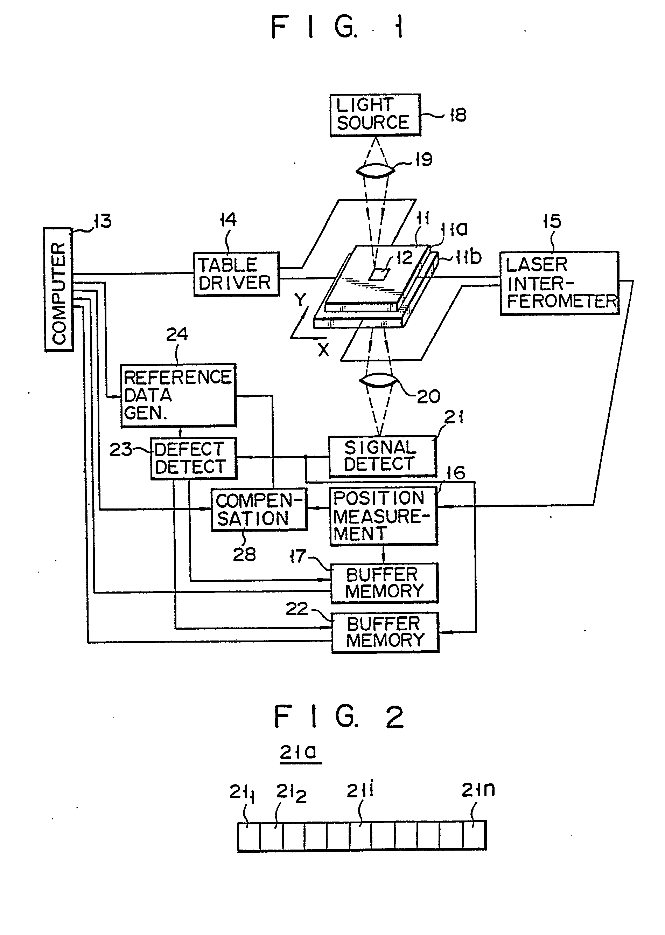

Referring to Fig. 1, a table 11 comprises an X table 11b movable in an X direction, and a Y table 11a which is placed on X table 11b and movable in a Y direction. A photomask to be inspected is placed on Y table 11a. The table 11 is driven by a table driver 14 which operates in response to a command issued from a computer 13. The position of table 11 is measured by a laser interferometer 15. The measured position data of Table 11 is sent to a position measuring unit 16. The position measuring unit 16 calculates the position of the present measured point on photomask 12 on the basis of position calculating parameters from computer 13. The position data obtained by position measuring unit 16 is temporarily stored in a buffer memory 17 and is transferred to computer 13.

A light source 18 is located above table 11. Light emitted by light source 18 is focused by a lens 19, and projected onto photomask 12 placed on table 11. The light transmitted through photomask 12 is imaged, by means of a lens 20, on an image sensor 21a of an image detector 21 which is fixedly disposed. The image sensor 21a comprises a plurality of sensor elements $21_1$—$21n$ arrayed in one line, as shown in Fig. 2. From image sensor 21a, an analog measured signal is read out for every measured point in synchronism with the movement of table 11. The read out analog signal is then converted into a multi-level digital signal. The digital signal produced from signal detector 21 is temporarily stored in a buffer memory 22, and then is transferred to computer 13. The measured digital signal is also transferred to a defect detector 23.

A reference data generator 24 is provided which, as described in EP—A1—105661, produces for every measured point a reference data signal of a multi-level, which allows for the sensitivity characteristic of the image sensor 21a, based on the pattern design data from computer 13 and the position data of the measured point from position measuring unit 16. The reference data signal is compared with the measured data signal from signal detector 21 in defect detector 23. The defect detector 23 compares both data, and when detecting a difference between them above a specified value, decides that a circuit pattern on the photomask contains some defect. When the defect is detected, defect detector 23 stores the measured data from signal detector 21 in data buffer memory 22 and also stores in a buffer memory 17 the position data of the defective portion of the photomask, which is derived from position measuring unit 16.

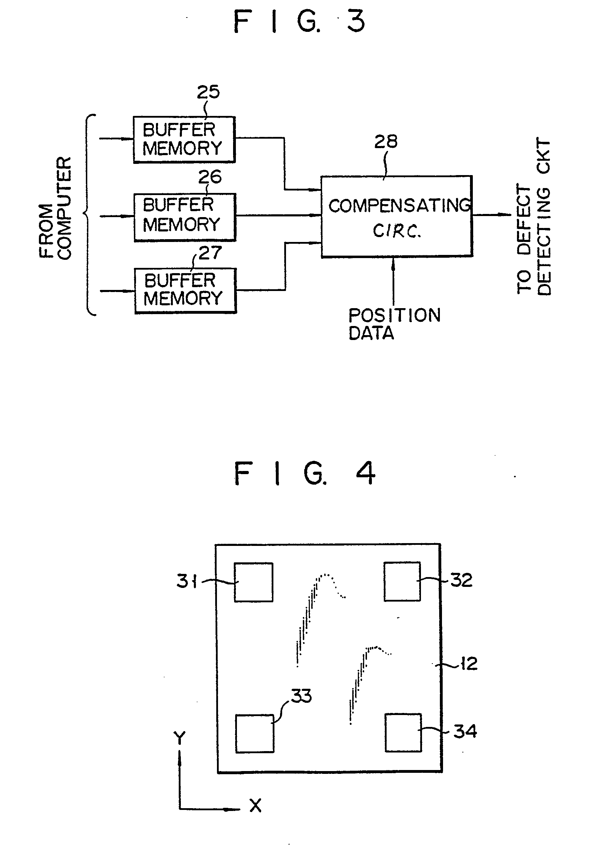

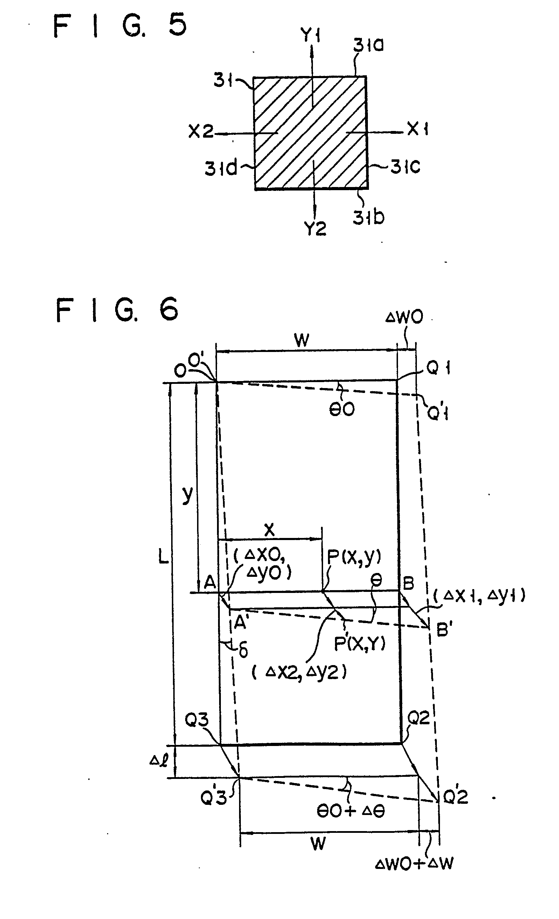

A compensating circuit 28 comprises data buffers 25, 26, 27, as shown in Fig. 3. Using the center positions of the position detecting marks on the photomask, the computer 13 calculates the varying amount δ, θo, Δθ of orthogonal degree,

the Y-direction expansion (contraction) amount $\Delta$ and X-direction expansion (contraction) amounts $\Delta Wo$, $\Delta W$ as shown in Fig. 6. In Fig. 6, the region $O \ Q_1 \ Q_2 \ Q_3$ (solid lines) represents the pattern region on the mask that the image sensor actually measures, and the region $O' \ Q'_1 \ Q'_2 \ Q'_3$ (broken lines) represents the corresponding region of the design pattern. $\delta$ is the amount of angle displacement of the left side of the pattern region, $\theta o$ is that of the upper side, $\Delta\theta$ is the difference between the angle displacement amount of the upper and lower sides, $\Delta l$ is the amount of expansion (contraction) of the left side, $\Delta Wo$ is the expansion (contraction) of the upper side, and $\Delta W$ is the difference between the extraction (contraction) amounts of the upper side and the lower side. These values can be geometrically calculated from the coordinates of corner points $O'$, $Q'_1$, $Q'_2$, $Q'_3$ of the design region, corresponding to the corner points $O$, $Q_1$, $Q_2$, $Q_3$ of the measured region, which are calculated from the center positions of position-detecting marks 31—33 shown in Fig. 4 using interpolation calculations. Fig. 6 shows the pattern region of the mask and the designed pattern moved in parallel so that O and O' may assume the same position.

When three position-detecting marks are used, the data $\Delta W$, $\Delta\theta$ cannot be obtained. Therefore, the designed pattern region $O' \ Q'_1 \ Q'_2 \ Q'_3$ is regarded as a parallelogram ($\Delta W=0$, $\Delta\theta=0$). Nonetheless, it has been experimentally ascertained that three position-detecting marks suffice to inspect the mask at high accuracy as long as the angle variation of sides and expansion (contraction) are relatively small.

In Fig. 6, a line AB indicates a portion which is measured by one scanning operation of the image sensor. Point A shows the scanning start position and point B shows the scanning end position. A' and B' represent the positions on the designed data corresponding to A and B, respectively. The following equations are approximately derived from Fig. 6:

$$\Delta xo = \delta \cdot y$$

$$\Delta yo = \frac{y}{L} \cdot \Delta l$$

$$\theta = \theta o + \frac{y}{L} \cdot \Delta\theta$$

$$\Delta x_1 = \Delta Wo + \frac{y}{L} \cdot \Delta W$$

$$\Delta y_2 = x \cdot \theta$$

$$\Delta x_2 = \frac{x}{W} \cdot \Delta x_1$$

Further:

$$X = x + \Delta xo + \Delta x_2$$

$$Y = y + \Delta yo + \Delta y_2$$

Based on the above calculations, the position data (X, Y) of point P' on the designed pattern corresponding to the position data (x, y) of the measured point P of the measured pattern can be determined. The compensation circuit 28 of Fig. 3 performs the above-mentioned compensating calculations. The data representing the varying amounts $\delta$, $\theta o$, $\Delta\theta$ of the pattern orthogonal degree, and the Y-direction expansion (contraction) amount $\Delta l$ and the X-direction expansion (contraction) amount $\Delta Wo$, $\Delta W$ of the mask are stored in buffer memories 25, 26, 27, respectively. In compensating circuit 28, the position data of each measured point is corrected by using the data applied from buffer memories 25, 26, 27 in accordance with the above calculation expressions. Namely, as shown in Fig. 6, the position data (x, y) representing a measured point P on the measured pattern region $O \ Q_1 \ Q_2 \ Q_3$ is corrected to represent the position (X, Y) of the corresponding point P' on the design pattern region $O' \ Q'_1 \ Q'_2 \ Q'_3$. Subsequently, the defect deciding circuit 23 compares the reference data with the measured data signal from signal detector 21. When detecting a defect, the defect deciding circuit 23 stores the position data of the defective portion and the measured data into buffer memories 17 and 22, respectively.

The photomask inspection apparatus according to the present invention has two operation modes, a mode for photomask position detection and a subsequent mode for circuit pattern inspection. In the position detecting mode, the center positions of three or more position detecting marks 31—34 located at the corners of the photomask are detected using signal detector 21 to align the photomask with the optical detecting system, and the geometrical distortion amounts of the photomask are calculated using the center positions of the detected position detecting marks.

In the position detecting mode, the center positions of the position detecting marks can be detected by the method as described in the above-mentioned prior application EP—A1—114517. In this mode, table 11 is positioned so that the center of positioning mark 31 of photomask 12 almost coincides with an optical axis of the optical system. Then, the positioning mark is illuminated by light source 18. The signal detector 21 is driven while Y table 11a is moved in the Y1 direction (orthogonal to the array direction of the image sensor elements of the image sensor). Through this operation, detected signals for mark 31 are sequentially read out from the image sensor elements. The measured data readout is stored into data buffer 22. At the same time, the position measuring unit 16 stores into data buffer 17 data regarding the positions on the photomask, which correspond to the image sensor elements, respectively. The computer 13 calculates the position of an edge 31a of mark 31 by analyzing the measured signal and the position data. Then, by moving Y table 11a in the direction Y2 opposite to Y1, the computer 13 calculates the position of edge 31b on the basis of the measured signal and the position data, which are associated with edge 31b. The computer 13 further calculates the center position of mark 31 in the Y direction using the positions of edges 31a and 31b.

Then, the X table 11b is moved in an X1 direction (the array direction of the image sensor elements). During this movement of X table 11b, the position of an edge 31c of mark 31 is obtained. Further, the position of an edge 31d of mark 31 is obtained while X table 11b is moved in the direction X2 opposite to X1. Using the positions of edges 31c and 31d, the center position of mark 31 in the X direction is calculated. The center position of mark 31 is obtained on the basis of the center positions in the X and Y directions.

Subsequently, the center positions of remaining marks 32, 33 and 34 are obtained in a similar way. The computer 13 can calculate the variation amount of the orthogonal degree and the amount of expansion (contraction) of the circuit pattern by using the detected center positions of at least three marks.

The variation amount of the orthogonal degree of the circuit pattern and the expansion (contraction) of the photomask are stored in buffer memories 25—27 shown in Fig. 3. Subsequently, the mode for inspecting the circuit pattern is executed. In this mode, the circuit pattern on the photomask is illuminated with light, and the measured signals are derived from signal detector 21.

The measured-position data for reading out the reference data signal from reference data generator 24 is corrected according to the amount of geometrical distortion of the photomask. That is, the reference data is equivalently corrected. The corrected reference data signal is compared with the measured data signal. Accordingly, a highly accurate inspection of the circuit pattern is guaranteed which is free from the geometrical distortion of the photomask.

In addition to the inspection of a photomask described above, this invention may be applied to the inspection of an electron beam transfer mask, an X-ray transfer mask and the like. In the above embodiment measured signals are obtained from the light passing through the mask. Instead, the light reflected from the mask may be used to generate measured signals. Also, in the above embodiment specific position detecting marks on the mask are used for measuring the geometrical distortion. However, some parts of integrated-circuit pattern on the mask may be used as position detecting marks. In this case, the specific position detecting marks are useless.

## Claims

1. A method of inspecting a mask (12) for use in manufacturing integrated circuits, said mask having at least three position detecting marks (31 to 34) and an integrated circuit pattern drawn thereon to be transferred onto a wafer, comprising the steps of:

storing reference integrated circuit patterns data signals for respective pixels of a designed integrated circuit pattern drawn on said mask;

placing said mask on an X—Y table for inspection;

driving said X—Y table in X and Y directions of said mask;

measuring a position of said X—Y table to provide a position signal used for addressing said storage means to read out a reference integrated circuit pattern data signal for each pixel of said mask;

optically sensing said circuit pattern of said mask placed on said X—Y table to provide measured integrated circuit pattern signals for the respective pixels of said mask;

comparing the measured integrated circuit pattern signals with the reference integrated circuit pattern data signals, read out of said storage means, for the respective pixels of said mask to detect a defect of said mask;

optically detecting said position detecting marks of said mask;

calculating a distortion of said mask on the basis of the detected positions of said position detecting marks of said mask; and

correcting the position signal obtained for each position of said X—Y table according to an amount of the distortion of said mask so that the comparison between the reference integrated circuit pattern data signal and the measured integrated circuit pattern signal is made for each of corresponding pixels of the designed integrated circuit pattern and the drawn integrated circuit pattern on said mask.

2. An apparatus for inspecting a mask (12) for use in manufacturing integrated circuits which has at least three position detecting marks (31 to 34) and an integrated circuit pattern drawn thereon to be transferred onto a wafer, comprising:

storage means (13) for storing reference integrated circuit pattern data signals for respective pixels of a designed integrated circuit pattern drawn on said mask;

an X—Y table (11) on which said mask can be placed for inspection;

table driving means (14) for driving said X—Y table in X and Y directions of said mask;

means (15) for measuring the position of said X—Y table to provide a position signal used for addressing said storage means to read out a reference integrated circuit pattern data signal for each pixel of said mask;

a source (18) of light for illuminating said mask placed on said X—Y table;

sensing means (21) responsive to the illumination of said mask placed on said table for providing measured integrated circuit pattern signals for the respective pixels of said mask;

comparing means (23) for comparing the measured integrated circuit pattern signals with the reference integrated circuit pattern data signals, read out of said storage means, for the respective pixels of said mask to detect a defect of said mask;

means (13) for detecting said position detecting marks of said mask placed on said table and calculating a geometrical distortion of said mask according to the detected positions of said position detecting marks; and

means (28) for correcting the position signal addressing said storage means and obtained for each position of said table according to an amount of the distortion of said mask so that the comparison between the reference integrated circuit pattern data signal and the measured integrated circuit pattern signal is made for each of corresponding pixels of the designed integrated circuit pattern and the drawn integrated circuit pattern on said mask.

3. An apparatus according to claim 2, characterized in that the distortion of said mask contains expansion and contraction of said mask in X and Y directions thereof and a variation in the orthogonal degree of said integrated circuit pattern.

4. An apparatus according to claim 2, characterized in that said sensing means includes a line image sensor (21a) for sensing light transmitted through said mask.

**Patentansprüche**

1. Verfahren zur Untersuchung einer Maske (12) für die Herstellung integrierter Schaltungen, wobei die Maske wenigstens drei Positionserfassungsmarken (31—34) und ein darauf gezeichnetes integriertes Schaltungsmuster hat, das auf eine Scheibe zu übertragen ist, mit den Schritten:

Speichern von Bezugs-Integrierte-Schaltung-Musterdatensignalen für jeweilige Pixels eines entworfenen integrierten Schaltungsmusters, das auf der Maske gezeichnet ist,

Anbringen der Maske auf einem X—Y-Tisch zur Untersuchung,

Antreiben des X—Y-Tisches in X- und Y-Richtungen der Maske, - Messen einer Position des X—Y-Tisches zur Lieferung eines Positionssignales, das zum Adressieren der Speichereinrichtung verwendet wird, um ein Bezugs-Integrierte-Schaltung-Musterdatensignal für jedes Pixel der Maske auszulesen, optisches Abfühlen des Schaltungsmusters der auf dem X—Y-Tisch liegenden Maske, um für die jeweiligen Pixels der Maske Meß-Integrierte-Schaltung-Mustersignale zu liefern,

Vergleichen der Meß-Integrierte-Schaltung-Mustersignale mit den aus der Speichereinrichtung ausgelesenen Bezugs-Integrierte-Schaltung-Musterdatensignalen für die jeweiligen Pixels der Maske zum Erfassen ein Fehlers der Maske,

optisches Erfassen der Positionserfassungsmarken der Maske,

Berechnen einer Verzerrung der Maske aufgrund der erfaßten Positionen der Positionserfassungsmarken der Maske und

Korrigieren des für jede Position des X—Y-Tisches erhaltenen Positionssiganles gemäß einem Wert der Verzerrung der Maske, so daß der Vergleich zwischen dem Bezugs-Integrierte-Schaltung-Musterdatensignal und dem Meß-Integrierte-Schaltung-Mustersignal für jedes entsprechende Pixel des entworfenen integrierten Schaltungsmusters und des gezeichneten integrierten Schaltungsmusters auf der Maske vorgenommen wird.

2. Apparat zur Untersuchung einer Maske (12) für die Herstellung von integrierten Schaltungen, welche wenigstens drei Positionserfassungsmarken (31—34) und ein darauf gezeichnetes integriertes Schaltungsmuster hat, das auf eine Scheibe zu übertragen ist, mit:

einer Speichereinrichtung (13) zum Speichern von Bezugs-Integrierte-Schaltung-Musterdatensignalen für jeweilige Pixels eines entworfenen integrierten Schaltungsmusters, das auf die Maske gezeichnet ist,

einem X—Y-Tisch (11), auf den die Maske zur Unterzuchung gelegt werden kann,

einer Tischantriebseinrichtung (14) zum Antrieben des X—Y-Tisches in X- und Y-Richtungen der Maske,

einer Einrichtung (15) zum Messen der Position des X—Y-Tisches, um ein Positionssignal zu liefern, das zum Adressieren der Speichereinrichtung verwendet wird, um ein Bezugs-Integrierte-Schaltung-Musterdatensignal für jedes Pixel der Maske auszulesen,

einer Lichtquelle (18) zum Beleuchten der auf dem X—Y-Tisch liegenden Maske,

einer Fühlereinrichtung (21), die auf die Beleuchtung der auf dem Tisch liegenden Maske anspricht, um Meß-Integrierte-Schaltung-Mustersignale für die jeweiligen Pixels der Maske zu liefern,

einer Vergleichereinrichtung (23) zum Vergleichen der Meß-Integerierte-Schaltung-Mustersignalen mit den Bezugs-Integrierte-Schaltung-Musterdatensignale, die aus der Speichereinrichtung ausgelesen sind, für die jeweiligen Pixels der Maske, um einen Fehler der Maske zu erfassen,

einer Einrichtung (13) zum Erfassen der Positionserfassungsmarken der auf dem Tisch liegenden Maske und zum Berechnen einer geometrischen Verzerrung der Maske gemäß den erfaßten Positionen der Positionserfassungsmarken, und

einer Einrichtung (28) zum Korrigieren des Positionssignales, das die Speichereinrichtung adressiert und für jede Position des Tisches erhalten ist, gemäß einem Wert der Verzerrung der Maske, so daß der Vergleich zwischen dem Bezugs-Integrierte-Schaltung-Musterdatensignal und dem Meß-Integrierte-Schaltung-Mustersignal für jedes der entsprechenden Pixels des entworfenen integrierten Schaltungsmusters und des gezeichneten integrierten Schaltungsmusters auf der Maske vorgenommen wird.

3. Apparat nach Anspruch 2, dadurch gekennzeichnet, daß die Verzerrung der Maske eine Expansion und Kontraktion der Maske in X- und Y-Richtungen hiervon und eine Änderung im orthogonalen Grad des integrierten Schaltungsmusters enthält.

4. Apparat nach Anspruch 2, dadurch gekennzeichnet, daß die Fühlereinrichtung einen Linienbildfühler (21a) zum Abtasten des durch die Maske übertragenen Lichtes hat.

## Revendications

1. Procédé pour inspecter un masque (12) destiné à être utilisé dans la fabrication de circuits intégrés, le masque portant au moins trois repères de détection de position (31 à 34) et un tracé de circuit intégré dessiné sur lui et devant être transféré sur une plaquette, comprenant les opérations qui consistent à:

mémoriser des signaux d'information de référence du tracé du circuit intégré pour des pixels respectifs d'un tracé de consigne du circuit intégré devant être dessiné sur ce masque;

placer le masque sur une table X—Y pour l'inspection;

déplacer cette table suivant des directions X et Y du masque;

mesurer la position de la table pour fournir un signal de position utilisé pour l'adressage du moyen du mémorisation en vue de la lecture d'un signal d'information de référence du tracé du circuit intégré pour chaque pixel du masque;

explorer optiquement le tracé du circuit du masque placé sur la table X—Y pour fournir des signaux de mesure du tracé du circuit intégré pour les pixels respectifs du masque;

comparer les signaux de mesure du tracé du circuit intégré avec les signaux d'information de référence du tracé du circuit intégré, lus du moyen de mémorisation, pour les pixels respectifs du masque, en vue de la détection d'un défaut éventuel du masque;

détecter optiquement les repères de détection de position du masque;

calculer une déformation éventuelle du masque sur la base des positions détectées des repéres de détection de position; et

corriger le signal de position obtenu pour chaque position de la table X—Y en fonction d'une grandeur de la déformation du masque, de telle sorte qu'une comparison entre le signal d'information de référence du tracé du circuit intégré et le signal de mesure du tracé du circuit intégré est opérée pour chacun des pixels correspondants du tracé de consigne, du circuit intégré et du tracé du circuit intégré dessiné sur ls masque.

2. Appareil pour inspecter un masque (12) destiné à être utilisé dans la fabrication de circuits intégrés et qui porte au moins trois repères de détection de position (31 à 34) et un tracé de circuit intégré dessiné sur lui et devant être transféré sur une plaquette, comprenant:

un moyen de mémorisation (13) pour mémoriser des signaux d'information de référence du tracé du circuit intégré pour des pixels respectifs d'un tracé de consigne du circuit intégré devant être dessiné sur ce masque;

une table X—Y (11) sur laquelle ce masque peut être placé en vue de l'inspection;

un moyen de déplacement de table (14) pour déplacer la table X—Y suivant des directions X et Y du masque;

un moyen (15) pour mesurer la position de la table X—Y afin de fournir un signal de position utilisé pour l'adressage du moyen de mémorisation en vue de la lecture d'un signal d'information de référence du tracé du circuit intégré pour chaque pixal du masque;

une source de lumière (18) pour éclairer le masque placé sur la table X—Y;

un dispositif d'exploration (21) sensible à l'éclairement du masque placé sur la table et servant à fournir des signaux de mesure de tracé du circuit intégré pour les pixels respectifs du masque;

un moyen de comparison (23) pour comparer les signaux de mesure du tracé du circuit intégré avec les signaux d'information de référence du tracé du circuit intégré, lus du moyen de mémorisation, pour les pixels respectifs du masque, en vue de la détection d'un défaut éventuel du masque;

un moyen (13) pour détecter les repères de détection de position du masque placé sur la table et pour calculer une déformation géométrique éventuelle du masque d'après les positions détectées des repères de détection de position; et

un moyen (28) pour corriger le signal de position servant à l'adressage du moyen de mémorisation et obtenu pour chaque position de la table, en fonction d'une grandeur de la déformation du masque, de telle sorte qu'une comparaison entre le signal d'information de référence du tracé du circuit intégré et le signal de mesure du tracé du circuit intégré est opérée pour chacun des pixels correspondants du tracé de consigne du circuit intégré et du tracé du circuit intégré dessiné sur le masque.

3. Appareil selon la revendication 2, caractérisé en ce que la déformation du masque contient une dilatation et une contraction du masque dans les directions X et Y de celui-ci, ainsi qu'une variation dans la degré d'orthogonalité du tracé du circuit intégré.

4. Appareil selon la revendication 2, caractérisé en ce que le moyen d'exploration comporte un capteur d'image linéaire (21a) pour capter de la lumière transmise à travers le masque.

# F I G. 1

LIGHT SOURCE ~18

19

13 COMPUTER

14 TABLE DRIVER

11 11a
12 11b

15 LASER INTER-FEROMETER

Y

X

24 REFERENCE DATA GEN.

20

23 DEFECT DETECT

21 SIGNAL DETECT

16 POSITION MEASURE-MENT

28 COMPEN-SATION

17 BUFFER MEMORY

22 BUFFER MEMORY

# F I G. 2

21a

21₁ 21₂ 21i 21n

# F I G. 3

BUFFER MEMORY — 25

BUFFER MEMORY — 26

BUFFER MEMORY — 27

FROM COMPUTER

COMPENSATING CIRC. — 28

POSITION DATA

TO DEFECT DETECTING CKT

# F I G. 4

31

32

33

34

12

Y

X

# F I G. 5

# F I G. 6